# FASCICULE DE BREVET EUROPEEN

(11) **EP 0 762 659 B1**
(45) Date de publication et mention de la délivrance du brevet: **04.06.2003**
(21) Numéro de dépôt: 96410091.1
(22) Date de dépôt: 27.08.1996
(51) Int. Cl.: H03M 13/00

(54) **Décodeur convolutif utilisant l'algorithme de Viterbi**
Faltungsdekoder unter Verwendung des Viterbi-Algorithmus
Convolutional decoder using the Viterbi algorithm

(30) Priorité: 31.08.1995 FR 9510402
(43) Date de publication de la demande: 12.03.1997
(73) Titulaire: STMicroelectronics S.A., 92120 Montrouge (FR)
(72) Inventeur: Meyer, Jacques, 38700 Corenc (FR)
(74) Mandataire: de Beaumont, Michel

(56) Documents cités:
- EP-A- 0 632 612
- US-A- 5 027 374
- IEEE TRANSACTIONS ON COMMUNICATION, vol. 41, no. 4, 1 Avril 1993, NY,USA, pages 636-644, XP000372705 C. SHUNG ET AL.: "Area Efficient Architectures for the Viterbi Algorithm-Part I: Theory"
- IEICE TRANSACTIONS ON FUNDAMENTALS OF ELECTRONICS, COMMUNICATIONS AND COMPUTER SCIENCES, vol. 76a, no. 9, 1 Septembre 1993, TOKYO,JAPAN, pages 1422-1429, XP000411515 T. YAMAZATO ET AL.: "A new Viterbi Algorithm with Adaptive Path Reduction Method"

## Description

La présente invention concerne un décodeur convolutif utilisant l'algorithme de Viterbi. Le codage convolutif est utilisé dans les transmissions de données pour diminuer les probabilités d'erreur.

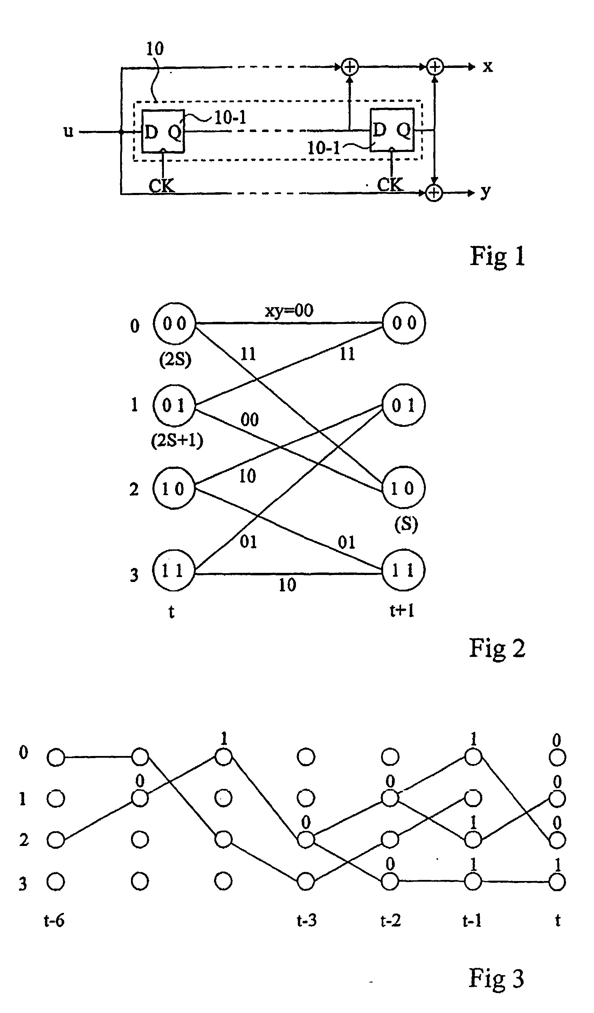

La figure 1 illustre un codeur convolutif classique. Un signal binaire u est fourni à un registre à décalage de codage 10 comprenant plusieurs bascules 10-1 disposées en cascade et cadencées par une horloge CK. La fréquence de l'horloge CK est normalement égale à la fréquence de transmission des bits par le signal u. A partir des états des bascules 10-1, on établit deux signaux x et y représentant le signal u codé. Chacun de ces signaux x et y est obtenu en effectuant la somme (OU Exclusif) de l'entrée u du registre à décalage, de la sortie du registre à décalage, et d'états intermédiaires du registre à décalage, les états intermédiaires étant en général différents pour les signaux x et y.

La figure 2 représente un exemple de graphe, appelé treillis, illustrant les transitions possibles des états du registre à décalage à deux instants consécutifs t et t+1, ainsi que les valeurs correspondantes des signaux x et y. Cet exemple correspond à un treillis de taille 4 (c'est-à-dire que le registre à décalage de codage comporte deux bascules), le signal x étant la somme du signal u et des sorties de toutes les bascules, et le signal y étant la somme du signal u et de la sortie du registre à décalage. Les états possibles du registre à décalage sont représentés en binaire à l'intérieur de cercles et valent 0, 1, 2 et 3 en décimal. Pour éviter une confusion entre valeurs binaires et décimales, les valeurs binaires seront suivies de la lettre "b" dans la description suivante. Les valeurs binaires des signaux x et y sont reportées sur des liaisons entre deux cercles qui représentent des transitions possibles. Ainsi, par exemple, lorsque le registre à décalage passe de l'état 00b (0) à l'état 10b (2), on a xy=11b.

En raison des propriétés du registre à décalage, un état S ne peut être atteint qu'à partir de l'état précédent 2S ou 2S+1 (modulo le nombre N d'états possibles). Par exemple, l'état 2 (10b) ne peut être atteint qu'à partir de l'état 0 (00b) ou 1 (01b) précédent. Si l'une de ces deux transitions possibles fournit des bits x et y, l'autre fournit les bits complémentaires x* et y*.

Le décodage convolutif consiste à retrouver d'une manière particulière les états successifs du registre à décalage de codage et par là les transitions du signal initial, en fonction des bits x et y reçus.

A chaque fois que l'on reçoit un couple de bits x et y, on calcule pour chacune des liaisons possibles entre les états un coût, plus couramment appelé métrique, correspondant à l'inverse de la probabilité de survenue de la transition représentée par la liaison. Par exemple, dans la figure 2, si l'on reçoit le couple de bits 00, les liaisons désignées par 00b sont affectées d'une métrique 0, les liaisons désignées par 10b et 01b sont affectées d'une métrique 1 et les liaisons désignées par 11b sont affectées d'une métrique 2. Ensuite, pour chaque état possible, parmi les deux liaisons qui lui parviennent, on retient celle qui a la métrique la plus faible, sous la forme d'une décision mémorisée. Pour être plus précis, pour décider si un état S est relié à un état précédent 2S ou 2S+1, on compare la somme des métriques des liaisons précédemment retenues permettant d'atteindre l'état S en passant par l'état 2S et la somme des métriques des liaisons précédemment retenues permettant d'atteindre l'état S en passant par l'état 2S+1. C'est alors la plus faible somme de métriques qui détermine la liaison courante à retenir.

La figure 3 montre un exemple de constitution de liaisons à des instants consécutifs dans le cas d'un treillis à quatre états (figure 2). Chacun des quatre nouveaux états associés à un couple de bits x et y que l'on vient de recevoir est relié à un seul état précédent, comme cela est montré à l'instant t. Quand on avance dans le temps, il se trouve que des états anciens, comme l'état 1 à un instant t-1, n'ont plus de successeurs, c'est-à-dire qu'ils ne sont plus reliés à un nouvel état. Alors, les liaisons successives qui avaient été retenues jusqu'à un tel état sans successeur disparaissent. Quand on avance suffisamment loin dans le temps, il subsiste un seul chemin reliant entre eux des états anciens consécutifs, comme entre les instants t-3 et t-6, vers lequel convergent tous les chemins de l'instant courant t. C'est ce chemin unique, antérieur à l'instant t-3, qui relie entre eux les états successifs par lesquels est passé le registre à décalage, et qui permet donc de retrouver les transitions du signal initial u.

Ce sont les décisions successivement mémorisées qui permettent de retrouver ce chemin unique. Pour cela, on part de l'une quelconque des quatre décisions mémorisées à l'instant courant t et on remonte les décisions dans le temps, c'est-à-dire dans l'ordre inverse de leur mémorisation. C'est ce que l'on désigne couramment dans la technique par le terme anglais "trace-back". Par exemple, la décision associée à l'état 1 à la figure 3 vaut 0 et pointe vers l'état 2 de l'instant t-1, dont la décision (1) pointe à son tour vers l'état 1 de l'instant t-2, etc.

Pour être sûr de tomber sur le chemin unique qui permet de retrouver les états du signal u, il faut remonter les décisions sur une longueur suffisante appelée longueur de convergence qui dépend du nombre N d'états possibles. Ce n'est que lorsque la longueur de convergence est atteinte que l'on peut commencer le décodage, c'est-à-dire la reconstitution des états du signal u, tout en continuant à remonter les décisions dans le temps. Les états du signal u, étant reconstitués dans l'ordre inverse, sont ensuite rétablis dans leur ordre initial à l'aide d'une mémoire d'inversion.

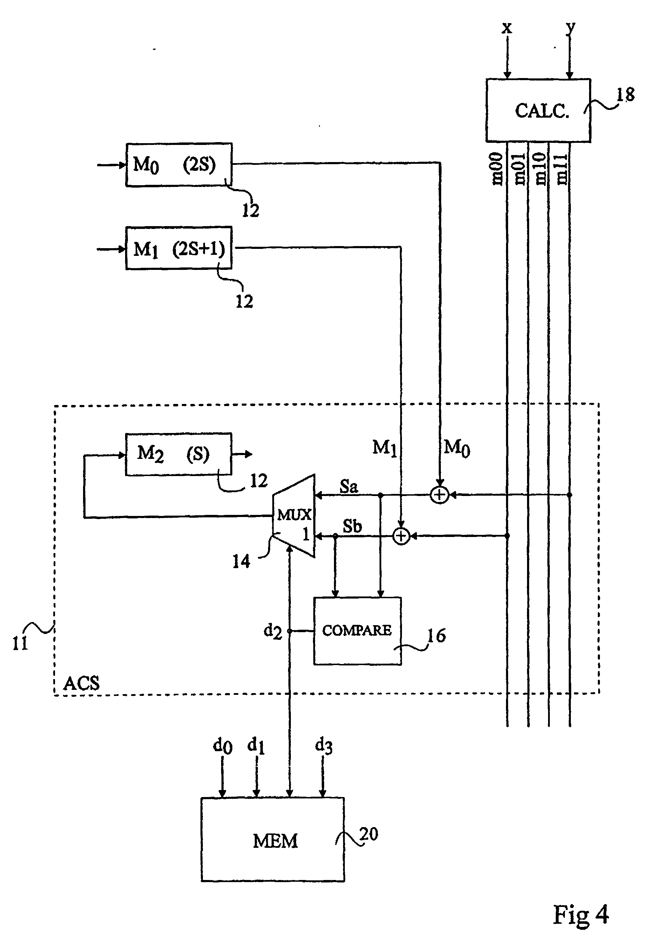

La figure 4 représente partiellement un décodeur convolutif classique pour un treillis à quatre états (figure 2). A chaque état est associée une cellule 11 d'addition-comparaison-sélection (ACS) dont une seule, associée à l'état 2, est représentée. Chacune des cellules ACS comporte un registre 12 qui stocke la somme M des métriques des liaisons aboutissant à l'état correspondant. Chaque registre 12 reçoit la sortie d'un multiplexeur 14 qui est commandé par la décision d d'un bit établie par la cellule ACS. Cette décision d est fournie par un comparateur 16 qui compare des sommes Sa et Sb qui sont également fournies aux entrées du multiplexeur 14. Dans le cas de la cellule ACS représentée, associée à l'état 2, la somme Sa est égale à la somme du contenu M₀ du registre 12 associé à l'état 0 et de la métrique m11 de la liaison entre l'état 2 courant et l'état 0 précédent. La somme Sb est égale à la somme du contenu M₁ du registre 12 associé à l'état 1 et de la métrique m00 de la liaison entre l'état 2 courant et l'état 1 précédent. Le comparateur 16 sélectionne, à l'aide du multiplexeur 14, la plus petite des valeurs Sa et Sb, la décision d fournie par le comparateur 16 étant à 1 si la valeur Sb est la plus petite.

De façon générale, une cellule ACS associée à un état S utilise les contenus des registres 12 associés aux états 2S et 2S+1 et les deux métriques m associées aux liaisons entre l'état S et les états 2S et 2S+1 précédents. Les deux métriques m nécessaires sont fournies par un circuit 18 qui calcule les quatre métriques possibles m00, m01, m10 et m11 à partir des bits x et y reçus.

Dans un décodeur convolutif simple, c'est-à-dire dont le treillis comporte un faible nombre d'états, la longueur de convergence est également faible. Les décisions établies par les cellules ACS sont alors stockées dans des registres de décisions dont la taille est égale à la longueur de convergence. Les contenus de ces registres sont gérés selon la méthode connue dans la littérature sous la dénomination "Register Exchange" (échange de registres). A l'aide de cette méthode, les bits de poids faible de chaque registre de décisions, dont le contenu est modifié à chaque réception d'un nouveau couple de bits x et y, indiquent directement un nouvel état du chemin unique. Par exemple, à la figure 3, le registre de décisions associé à l'état 1 contient, à l'instant t, la valeur 010010 et les deux bits de poids faible 10 désignent l'état 2 de l'instant t-6.

Dans des applications courantes actuelles des décodeurs convolutifs, le treillis est de 64 états. La longueur de convergence est alors d'environ 120 cycles ou bits, ce qui signifie que, si l'on utilise la méthode de l'échange de registres, il faut 64 registres de 120 bits. Ceci n'est plus envisageable pour des raisons d'encombrement et de coût. Dans ce cas, les décisions d fournies par toutes les cellules ACS sont stockées dans une mémoire 20 (figure 4).

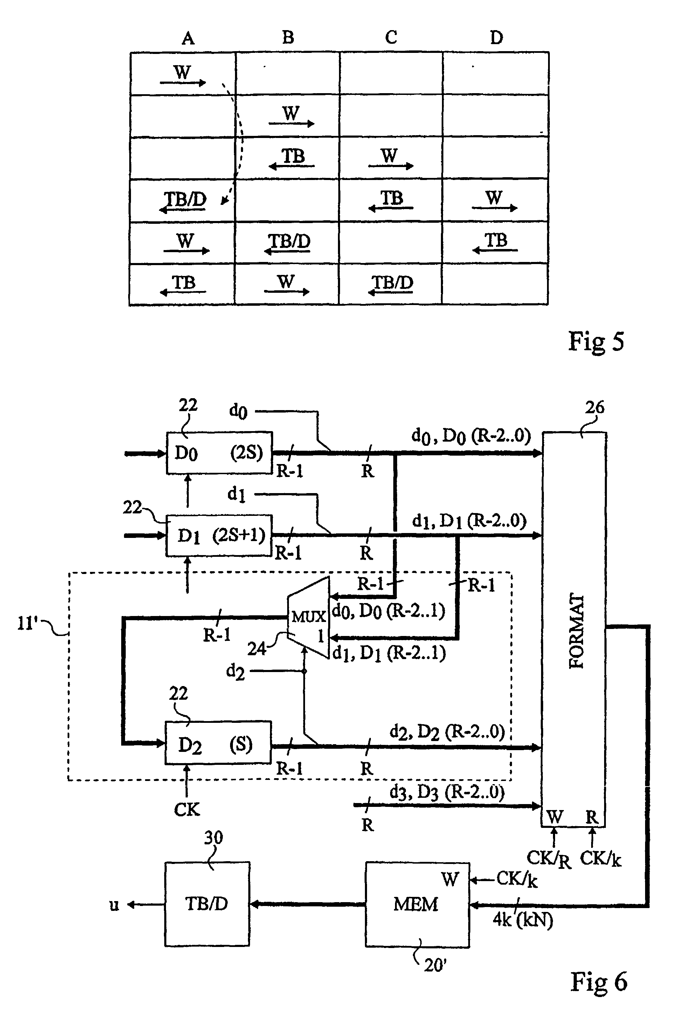

Comme le montre la figure 5, la mémoire 20 est en fait constituée de quatre mémoires A, B, C et D dont chacune a une taille de L mots de N bits, où L est la longueur de convergence et N la taille du treillis. Les décisions sont écrites (W) circulairement dans les mémoires A à D, c'est-à-dire que les mémoires A à D sont remplies successivement et, lorsque la mémoire D a été remplie, on recommence à remplir la mémoire A.

Le processus de décodage des décisions contenues dans la mémoire A est illustré par une flèche en pointillés. Après avoir rempli la mémoire A, on remplit également la mémoire B. Une fois la mémoire B remplie, les décisions stockées dans cette mémoire sont remontées en sens inverse (TB - "Trace-Back"). Cette remontée est effectuée à partir de l'une quelconque des N dernières décisions stockées dans la mémoire B. Lorsque l'on atteint le début de la mémoire B, on est sûr d'être sur le chemin unique. Alors on continue la remontée des décisions dans la mémoire A et on décode (TB/D) en même temps les états trouvés sur le chemin indiqué par les décisions que l'on remonte.

On doit effectuer pour chaque couple de valeurs x et y une écriture de décision en mémoire, une lecture pour remonter une décision, et une lecture pour décoder, tandis qu'une série de décisions est en attente de décodage. Etant donné que l'on veut opérer le plus rapidement possible, les trois accès en mémoire sont simultanés. Par conséquent, il faut quatre mémoires distinctes.

La fréquence de fonctionnement du décodeur convolutif, notamment des cellules ACS et des mémoires est égale à la fréquence de transmission des signaux x et y, c'est-à-dire à la fréquence de l'horloge CK qui cadence le registre à décalage de codage 10. Les fréquences de transmission actuelles sont d'environ 60 MHz, ce qui est pratiquement à la limite de la fréquence de fonctionnement des mémoires courantes peu coûteuses. Bien entendu, on souhaite de plus en plus augmenter la fréquence de transmission sans pour autant utiliser des mémoires plus rapides qui sont notablement plus chères.

Une solution pour doubler la fréquence de transmission sans doubler la vitesse de la mémoire est proposée dans un article de IEEE Journal of Solid-State Circuits, vol. 27, N° 12, décembre 1992 "A 140-Mb/s, 32-State, Radix-4 Viterbi Decoder". Cet article propose des cellules ACS qui calculent des décisions de 2 bits à la moitié de la fréquence de transmission. Chaque décision de deux bits permet de remonter à une décision établie deux cycles plus tôt et donc de lire dans la mémoire deux fois moins vite. Par contre, pour écrire dans la mémoire également deux fois moins vite, les N décisions de deux bits doivent être écrites simultanément dans la mémoire. Par conséquent, la taille du bus de la mémoire doit être doublée. Le principe utilisé pour calculer les décisions de deux bits consiste, au lieu de considérer les deux liaisons d'un état courant S aux deux états précédents 2S et 2S+1, à considérer les quatre liaisons entre l'état S et les états 4S, 48+1, 4S+2, et 4S+3 (module N) qui précèdent les états 2S et 2S+1. (Le terme Radix-4 signifie que l'on tient compte de quatre liaisons arrivant sur chaque état). Il en résulte, entre autres, que chaque cellule ACS doit effectuer six comparaisons pour trouver la plus faible somme de métriques parmi quatre, au lieu d'une seule comparaison. I1 s'avère que la complexité du décodeur augmente d'un facteur supérieur à 2.

L'article de "Intégration, the VLSI Journal 12", novembre 1991, N°1 "An area-efficient path memory structure for VLSI implementation of high speed Viterbi decoders" utilise un algorithme de décodage combinant les avantages de l'algorithme d'échange de registre REA ("Register Exchange Algorithm") et de l'algorithme TBA ("Trace Back Algorithm").

Un objet de la présente invention est de prévoir un décodeur convolutif pouvant fonctionner à vitesse élevée sans augmenter la vitesse de fonctionnement de la mémoire, mais qui soit en outre de complexité relativement faible.

Un autre objet de la présente invention est de prévoir un tel décodeur convolutif qui permette de réduire la taille de la mémoire.

Ces objets sont atteints en prévoyant dans chaque cellule ACS un registre de décision de plusieurs bits mis à jour par la méthode "d'échange de registres" ("Register Exchange"). Par rapport à la méthode d'échange de registres classique, les registres de décision des cellules ACS selon l'invention ont une taille R de quelques bits seulement et n'atteignant en tout cas jamais la longueur de convergence. A chaque fois que les contenus des registres de décision ont été entièrement renouvelés, c'est-à-dire quand ils contiennent des nouvelles décisions complexes, ces décisions sont écrites dans une mémoire où elles sont relues, afin de les remonter, à une fréquence inversement proportionnelle à leur taille R. La fréquence d'écriture dans la mémoire est inversement proportionnelle à la taille du bus d'écriture qui est seulement limitée par les contraintes de réalisation de ce bus dans un circuit intégré.

Les cellules ACS selon l'invention établissent les bits successifs des décisions complexes à la cadence d'un bit par cycle et fonctionnent donc à la fréquence de transmission que l'on cherche à augmenter. Ceci n'est pas un inconvénient car la fréquence de fonctionnement du décodeur est essentiellement limitée par la fréquence de fonctionnement de la mémoire et non par celle des cellules ACS, puisque les technologies courantes permettent de réaliser de tels circuits logiques fonctionnant à des fréquences notablement plus élevées que la fréquence de la mémoire.

L'invention vise plus particulièrement un décodeur convolutif comprenant une pluralité de cellules de calcul de décision associées respectivement à tous les états S possibles d'un treillis. Chaque cellule associée à un état courant S comprend un circuit d'addition-comparaison-sélection (ACS) qui, à partir des valeurs courantes des deux signaux codés, fournit une décision d'un bit permettant de sélectionner l'un des états 2S et 2S+1 comme état précédant l'état courant S. Une mémoire stocke les décisions successives et un élément de décodage remonte la mémoire en sens inverse selon un chemin indiqué par les décisions stockées dans la mémoire afin de retrouver la succession d'états du signal initial. Chaque cellule de calcul associée à un état S comprend en outre des moyens pour établir une décision complexe de R bits constituée, par poids décroissants, de la décision d'un bit de la cellule et des R-1 bits de poids fort de la décision complexe établie par la cellule associée à l'état 2S ou 2S+1 sélectionné.

Le décodeur comprend un circuit de formatage pour transférer les décisions complexes dans la mémoire à une cadence adaptée à la taille d'un bus d'écriture de la mémoire.

Le treillis a N états possibles et la mémoire est munie d'un bus d'écriture de kN bits, où k est inférieur à R, le décodeur étant prévu pour stocker les N décisions complexes de R bits simultanément dans le circuit de formatage tous les R cycles et pour fournir ces décisions à la mémoire à raison d'un mot de kN bits tous les k cycles.

Selon un mode de réalisation de l'invention, la mémoire comprend deux mémoires dont chacune est subdivisée en R/k zones (R>k) de capacité NL/((R/k)-1), où L est le nombre de décisions d'un bit que l'on doit remonter avant d'atteindre des valeurs que l'on peut décoder, le décodeur étant prévu pour écrire des décisions de manière alternée dans les deux mémoires à raison d'une écriture tous les k cycles de manière à remplir toutes les zones circulairement, et pour effectuer les lectures nécessaires à la remontée des décisions dans les zones de la mémoire dans laquelle on n'écrit pas, à raison d'une lecture tous les k cycles.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, précédemment décrite, représente un codeur convolutif classique.
la figure 2, précédemment décrite, représente un treillis à quatre états dans le cadre d'un décodage convolutif ;
la figure 3, précédemment décrite, est destinée à illustrer, à l'aide d'un exemple, le processus de décodage convolutif ; la figure 4, précédemment décrite, représente partiellement un décodeur convolutif classique ;
la figure 5, précédemment décrite, représente une organisation de mémoire utilisée dans un décodeur convolutif classique
la figure 6 représente partiellement un mode de réalisation de décodeur convolutif selon la présente invention dans le cas d'un treillis à quatre états ;
la figure 7 représente un premier mode d'organisation de mémoire d'un décodeur convolutif selon la présente invention ; et
la figure 8 représente un deuxième mode d'organisation de mémoire d'un décodeur convolutif selon la présente invention.

La figure 6 représente une modification apportée, selon l'invention, à un décodeur convolutif classique du type de la figure 4, dans le cas d'un treillis à quatre états (figure 2). Un décodeur convolutif selon l'invention comporte tous les éléments d'un décodeur convolutif classique du type de la figure 4, qui ne sont pas représentés à la figure 6 pour des raisons de clarté.

Chaque cellule ACS comporte, selon l'invention, une extension 11' qui n'est représentée à la figure 6 que pour la cellule ACS associée à l'état 2. L'extension 11' associée à une cellule ACS est destinée à établir des décisions complexes de R bits à l'aide des décisions d'un bit établies normalement par les cellules ACS. Une décision complexe associée à un état est établie selon la méthode classique d'échange de registres, sauf que le nombre R de bits est faible par rapport à la longueur de convergence (le nombre R est de préférence choisi parmi les valeurs 2, 4 et 8). Les décisions complexes sont stockées dans une mémoire 20' de manière qu'on puisse les remonter en sens inverse sur la longueur de convergence nécessaire.

Chaque décision complexe permet, en un seul cycle, de remonter à une décision établie R cycles plus tôt. Ainsi, la cadence de lecture de la mémoire 20' peut être réduite d'un facteur R, à condition que l'on puisse lire au moins une décision complexe en un cycle (la largeur du bus de lecture de la mémoire est de R bits au moins). La cadence d'écriture de la mémoire 20' dépend seulement de la largeur de son bus. Si cette largeur est de kN bits (où N est la taille du treillis et k un entier, de préférence une puissance de 2), on effectue une écriture tous les k cycles, puisqu'on doit respecter un débit de N décisions d'un bit par cycle. Ainsi, on choisit le nombre k pour obtenir un compromis entre la diminution souhaitée de la fréquence d'écriture et la complexité de réalisation du bus mémoire.

Chacune des extensions 11' comprend un registre de décision 22 de R-1 bits qui charge, à chaque cycle d'horloge CK, la sortie d'un multiplexeur 24 commandé par la décision d établie par la cellule ACS associée. Une première entrée du multiplexeur 24 associé à l'état 2 reçoit, par ordre de poids décroissants, la décision d'un bit d₀ établie par la cellule ACS associée à l'état 0 ainsi que les R-2 bits de poids fort du registre de décision 22 associé à l'état 0. Une deuxième entrée du multiplexeur 24 reçoit la décision d'un bit d₁ établie par la cellule ACS associée à l'état 1 et les R-2 bits de poids fort du registre de décision 22 associé à l'état 1. L'état haut de la décision d'un bit d₂ associée à l'état 2 sélectionne la deuxième entrée du multiplexeur 24, c'est-à-dire les bits associés à l'état 1. La décision complexe de R bits associée à l'état 2 est obtenue en juxtaposant la décision d'un bit d₂, en tant que bit de poids le plus fort, à la sortie du registre 22 associé.

De façon générale, une extension 11' associée à un état S établit une décision complexe de R bits à chaque cycle d'horloge CK, cette décision complexe étant constituée, par ordre de poids décroissants, de la décision d'un bit d_{S} établie par la cellule ACS et des R-1 bits de poids fort de la décision complexe établie par l'extension 11' associée à l'état 2S ou 2S+1 sélectionné par la décision d'un bit d_{S}.

Une décision complexe est modifiée à chaque cycle d'horloge et permet à chaque cycle de remonter à une décision établie R cycles plus tôt. Ainsi, il suffit de stocker les N décisions complexes associées aux N états une fois tous les R cycles. Pour effectuer cela directement, la largeur du bus mémoire doit être de R×N bits. Dans ce cas, on effectue une écriture dans la mémoire tous les R cycles.

Toutefois, le nombre N est souvent relativement grand, par exemple égal à 64, et on préfère ne pas réaliser des bus de largeur supérieure à 128 bits pour ne pas rendre trop complexe sa réalisation intégrée.

En pratique, la largeur du bus mémoire est choisie à kN bits, où k est inférieur à R et au moins égal à 2. Dans ce cas, on prévoit entre la mémoire 20' et les registres de décision 22, un circuit de formatage 26 qui permet de transférer les décisions complexes dans la mémoire 20' à une cadence adaptée. Le circuit de formatage 26 est, par exemple, un convertisseur parallèle-série dans lequel on écrit simultanément N décisions complexes de R bits à une cadence d'une écriture tous les R cycles ( CK/R ) et dans lequel on lit les N décisions en R/k mots de kN bits à une cadence d'une lecture tous les k cycles (CK/k).

Pour remonter les décisions complexes dans la mémoire 20', un circuit de décodage 30 procède de la manière suivante. L'une quelconque des N décisions dernièrement stockées, par exemple la première, est prise pour commencer. Si le nombre R de bits est suffisant pour coder les N états, les bits de poids faible de chaque décision complexe pointent directement vers l'une des N décisions précédemment stockées. Si le nombre R est insuffisant, chaque décision complexe est complétée, au niveau de ses poids forts, par les poids faibles de l'état associé à la décision.

Puisque chaque décision permet de remonter à une décision établie R cycles plus tôt, la cadence de lecture de la mémoire 20' est d'une décision tous les R cycles, indépendamment de la taille du bus de cette mémoire. Si le bus mémoire est tel que l'on lit plusieurs décisions à la fois, c'est la décision précédente, éventuellement complétée par les bits de poids faible de l'état associé, qui indique laquelle des plusieurs décisions lues en même temps est celle que l'on doit retenir.

Comme on le remarque de ce qui vient d'être décrit, les cadences de lecture et d'écriture de la mémoire 20' peuvent être réglées indépendamment l'une de l'autre. Par contre, les cellules ACS 11 et leurs extensions 11' fonctionnent à la fréquence de l'horloge CK qui est égale à la fréquence de transmission. Ceci n'est pas désavantageux car c'est généralement le temps d'accès minimal à la mémoire qui limite la fréquence de fonctionnement du décodeur, les technologies actuelles permettant sans difficultés de réaliser les autres éléments du décodeur de manière qu'ils fonctionnent à des fréquences notablement plus élevées que la fréquence maximale d'accès aux mémoires.

Dans un décodeur convolutif selon l'invention, avec R=2 et k=2, on omet les registres de décision 22 et le circuit de formatage 26 et on obtient, avec une complexité notablement moindre, des caractéristiques semblables à celles d'un décodeur Radix-4 classique.

Des optimisations supplémentaires peuvent être obtenues avec des valeurs R supérieures à 2.

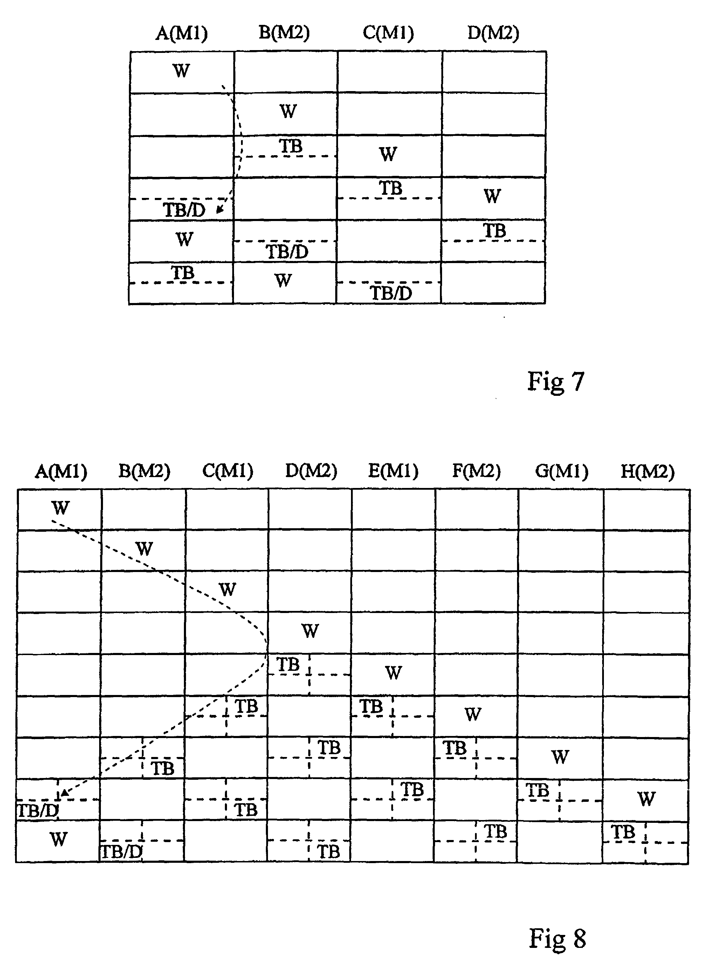

La figure 7 est destinée à illustrer une organisation de la mémoire 20' dans le cas où R=4 et k=2. Normalement, dans ce cas, on écrit dans la mémoire un cycle sur deux et on lit dans la mémoire un cycle sur quatre. Il est en fait peu utile que la cadence de lecture soit inférieure à la cadence d'écriture, puisque la mémoire doit être adaptée à supporter la plus rapide de ces deux cadences.

Selon un mode de réalisation de l'invention, la différence entre la cadence d'écriture et la cadence de lecture est exploitée pour diminuer le nombre des mémoires nécessaires ainsi que la taille de celles-ci.

Dans l'exemple de la figure 7, on utilise seulement deux mémoires M1 et M2, la mémoire M1 étant subdivisée en deux zones A et C, et la mémoire M2 étant subdivisée en deux zones B et D. Chacune de ces zones comporte L/2 mots de 2N bits (où L est la longueur de convergence). Comme dans la figure 5, les zones A à D sont remplies circulairement (W). Par contre, chacune des zones est remplie en L/2 écritures au lieu de L écritures à la figure 5. Pendant qu'on remplit la zone C, on remonte (TB) les décisions contenues dans la zone B pour atteindre la zone A en vue de remonter et décoder (TB/D) son contenu. Comme chaque décision permet de remonter de quatre cycles, on remonte la zone B en L/4 cycles, c'est-à-dire que, au moment où on a rempli la moitié de la zone C, on a terminé de remonter la zone B. Ceci est représenté par la référence TB située dans une moitié de case délimitée par des pointillés.

Tandis que l'on remplit la zone D, on a le temps de remonter la zone C en vue d'atteindre les données à décoder dans la zone B (ce qui est illustré par la référence TB dans une demi-case supérieure) et de remonter et décoder la zone A (ce qui est illustré par la référence TB/D dans une demi-case inférieure). Ceci permet de placer les zones C et A dans une même mémoire M1, puisque les zones C et A ne doivent plus être remontées simultanément, comme dans le cas de la figure 5, mais peuvent être remontées successivement tandis que l'on remplit la zone D. De façon générale, les deux zones d'une même mémoire sont remontées tandis que l'on écrit dans une zone de l'autre mémoire.

Ce mode de réalisation permet d'utiliser seulement deux mémoires dans le cas où il en fallait classiquement quatre, la quantité totale de la mémoire étant la même. La diminution du nombre de mémoires diminue d'autant le nombre de décodeurs d'adresses nécessaires et la surface correspondante.

La figure 8 illustre une organisation de mémoire selon l'invention dans le cas où R=8 et k=2. La mémoire est organisée en huit zones A à H, les zones A, C, E et G appartenant à une mémoire M1 et les zones B, D, F et H appartenant à une mémoire M2. Chacune des zones comporte L/6 mots de 2N bits. La taille totale de la mémoire est donc de 8NL/3 bits au lieu de 4NL bits à la figure 7, d'où il résulte une économie globale de 33 %.

Les zones A à H sont remplies (W) circulairement comme précédemment, chaque zone étant remplie en L/6 écritures. Avant de décoder le contenu de la zone A, il faut pouvoir remonter des décisions sur L cycles, c'est-à-dire qu'il faut avoir rempli les trois zones mémoire suivantes B, C et D. La remontée (TB) de la zone D commence tandis que l'on écrit dans la zone E. Puisque chaque décision permet une remontée de 8 cycles, chaque zone est remontée à une cadence quatre fois plus rapide que la cadence d'écriture (qui est déjà d'une écriture tous les deux cycles). Ceci est indiqué par une division en quatre parties par des pointillés de chacune des cases correspondant à une phase de remontée. Ainsi, tandis que l'on remplit la zone H dans la mémoire M2, on a le temps de remonter successivement les zones G, E, C et A de la mémoire M1. La remontée de la zone G correspond à la remontée du premier tiers des décisions qu'il faut remonter pour décoder le contenu de la zone D, la remontée de la zone E correspond à la remontée du deuxième tiers des décisions qu'il faut remonter pour décoder le contenu de la zone C, la remontée de la zone C correspond à la remontée du troisième tiers des décisions qu'il faut remonter pour décoder le contenu de la zone B, et finalement la zone A est remontée tandis qu'elle est en même temps décodée (TB/D).

De façon générale, plus le nombre R est grand par rapport à k, plus l'économie de mémoire est importante. Pour un nombre R quelconque, de préférence égal à une puissance de 2, on utilise deux mémoires dont chacune est subdivisée en R/k zones de NL/((R/k)-1) bits. Avant de décoder le contenu d'une zone, on remonte les (R/k)-1 zones suivantes, et, tandis que l'on écrit dans une zone de l'une des mémoires, on remonte les R/k zones de l'autre mémoire. Les cadences de lecture et d'écriture sont alors identiques et égales à un k-ième de la fréquence de transmission CK.

Dans le cas où les opérations de lecture d'une décision et du calcul de l'adresse de la décision précédente ne peuvent se terminer avant la lecture suivante, les lectures des zones d'une même mémoire seront entrelacées pendant l'écriture dans l'autre mémoire. C'est-à-dire, par exemple, que l'on lit une seule décision successivement dans les zones A, C, E, et G, ce qui laisse pour calculer une adresse entre deux décisions d'une même zone, le temps de lecture des trois autres zones.

## Revendications

1. Décodeur convolutif comprenant :
- une pluralité de cellules (11) de calcul de décision associées respectivement à tous les états S possibles d'un treillis, chaque cellule associée à un état courant S comprenant un circuit d'addition-comparaison-sélection (ACS) qui, à partir des valeurs courantes des deux signaux codés, fournit une décision d'un bit (d) permettant de sélectionner l'un des états 2S et 2S+1 comme état précédant l'état courant S ;
- une mémoire (20') dans laquelle sont stockées les décisions successives ; et
- un élément de décodage pour remonter la mémoire en sens inverse selon un chemin indiqué par les décisions stockées dans la mémoire afin de retrouver la succession d'états du signal initial ;
dans lequel chaque cellule de calcul associée à un état S comprend des moyens (11') pour établir une décision complexe de R bits constituée, par poids décroissants, de la décision d'un bit (d) de la cellule et des R-1 bits de poids fort de-la décision complexe établie par la cellule-associée à l'état 2S ou 2S+1 sélectionné ;
le décodeur comprenant un circuit de formatage (26) pour transférer les décisions complexes dans la mémoire à une cadence adaptée à la taille (kN) d'un bus d'écriture de la mémoire ;
**caractérisé en ce que** le treillis a N états possibles et la mémoire est munie d'un bus d'écriture de kN bits, où k est inférieur à R, le décodeur étant prévu pour stocker les N décisions complexes de R bits simultanément dans le circuit de formatage tous les R cycles et pour fournir ces décisions à la mémoire à raison d'un mot de kN bits tous les k cycles.

2. Décodeur selon la revendication 1, **caractérisé en ce que** la mémoire comprend deux mémoires (M1, M2) dont chacune est subdivisée en R/k zones (R>k) de capacité NL/((R/k)-1), où L est le nombre de décisions d'un bit que l'on doit remonter avant d'atteindre des valeurs que l'on peut décoder, le décodeur étant prévu pour écrire des décisions de manière alternée dans les deux mémoires à raison d'une écriture tous les k cycles de manière à remplir toutes les zones circulairement, et pour effectuer les lectures nécessaires à la remontée des décisions dans les zones de la mémoire dans laquelle on n'écrit pas, à raison d'une lecture tous les k cycles.

## Patentansprüche

1. Faltungsdekodierer, der Folgendes aufweist:
- eine Vielzahl von Entscheidungsberechnungszellen (11), die jeweils den möglichen Zuständen S eines Trellis bzw. Gitters zugeordnet sind, wobei jede Zelle einem aktuellen Zustand S zugeordnet ist, der eine Addier-Vergleichs-Auswahl (ACS= add-compare-select)-Schaltung aufweist, die aus den aktuellen Werten von den zwei enkodierten bzw. kodierten Signalen eine Ein-Bit-Entscheidung (d) vorsieht für das Auswählen von einem der Zustände 2S oder 2S⁺1 als ein Zustand, der dem aktuellen Zustand S vorangeht;
- einen Speicher (20'), in welchem die aufeinanderfolgenden Entscheidungen gespeichert werden; und
- ein Dekodierelement für das Rückverfolgen des Speichers gemäß einem Pfad, der durch die im Speicher gespeicherten Entscheidungen angezeigt ist, um die Abfolge der Zustände des anfänglichen bzw. ursprünglichen Signals wieder herzustellen;
wobei jede Berechnungszelle, die einem Zustand S zugeordnet ist, weiter Mittel (11') zum Erstellen einer komplexen R-Bit-Entscheidung aufweist, die gemäß abnehmender Gewichtung die Ein-Bit-Entscheidung (d) der Berechnungszelle und die R-1 signifikantesten Bits der komplexen Entscheidung aufweist, die durch die mit dem ausgewählten Zustand 2S oder 2S+1 zugeordnete Zelle erstellt wurde;
- wobei der Dekodierer eine Formatierungsschaltung (26) aufweist für das Transferieren der komplexen Entscheidungen in den Speicher mit einer Rate, die der Größe (kN) eines Schreibbusses des Speichers angepasst ist;
**dadurch gekennzeichnet, dass** das Trellis N mögliche Zustände hat und wobei der Speicher einen kN-Bit-Schreibbus aufweist, wobei k kleiner ist als R, wobei der Dekodierer operativ ist für das Speichern der N R-Bitkomplexen Entscheidungen simultan in der Formatierungsschaltung für jeden der R Zyklen und für das Liefern der Entscheidungen an den Speicher mit einer Rate von einem kN-Bit-Wort für jeden der k Zyklen.

2. Dekodierer nach Anspruch 1, **dadurch gekennzeichnet, dass** der Speicher zwei Speicher (M1, M2) aufweist, von denen ein jeder in R/k Bereiche (R>k) unterteilt ist, und zwar mit einer Größe NL/((R/k)-1), wobei L die Anzahl von Ein-Bit-Entscheidungen ist, die zurückverfolgt werden müssen bevor sie Werte erreichen, die dekodiert werden können, wobei der Dekodierer operativ ist zum abwechselnden Schreiben von Entscheidungen in die zwei Speicher mit einer Rate von einer Schreiboperation für jeden der k Zyklen, um so zirkular all die Bereiche zu füllen, und um die notwendigen Leseoperationen für die Rückverfolgung der Entscheidungen in den Bereichen des Speichers durchzuführen, in welche nicht geschrieben wird, und zwar mit einer Rate von einer Leseoperation für jeden der k Zyklen.

## Claims

1. A convolutive decoder including:
- a plurality of decision calculation cells (11) respectively associated with all the possible states S of a trellis, each cell associated with a current state S including an add-compare-select (ACS) circuit which, from current values of the two encoded signals, provides a one-bit decision (d) for selecting either one of states 2S or 2S+1 as a state preceding the current state S;
- a memory (20') in which the successive decisions are stored; and
- a decoding element for tracing back the memory according to a path indicated by the decisions stored in the memory in order to restore the succession of states of the initial signal;
wherein each calculation cell associated with a state S further includes means (11') for establishing a complex R-bit decision comprising, by decreasing weight, the one-bit decision (d) of the calculation cell and the R-1 most significant bits of the complex decision established by the cell associated with the selected state 2S or 2S+1;
- the decoder including a formatting circuit (26) for transferring complex decisions in the memory at a rate adapted to the size (kN) of a write bus of the memory;
**characterized in that** the trellis has N possible states and wherein the memory includes a kN-bit write bus, where k is smaller than R, the decoder being operative to store the N R-bit complex decisions simultaneously in the formatting circuit every R cycles and to provide said decisions to the memory at the rate of one kN-bit word every k cycles.

2. The decoder of claim 1, **characterized in that** the memory includes two memories (Ml, M2), each of which is partitioned into R/k areas (R>k) having a size NL/((R/k)-1), where L is the number of one-bit decisions that must be traced back before reaching values that can be decoded, the decoder being operative to alternately write decisions in the two memories at the rate of one write operation every k cycles so as to circularly fill all the areas, and to carry out the read operations necessary for the trace back of the decisions in the areas of the memory in which it is not written, at the rate of one read operation every k cycles.
